Europäisches Patentamt

European Patent Office

Office européen des brevets

(11) Publication number: **0 111 371 B1**

(12) **EUROPEAN PATENT SPECIFICATION**

(45) Date of publication of patent specification: **25.11.87**

(51) Int. Cl.⁴: **G 03 F 7/18,** B 41 C 1/18, B 41 N 1/22

(21) Application number: **83201732.1**

(22) Date of filing: **06.12.83**

(54) **A method of forming a printing sleeve.**

(30) Priority: **08.12.82 NL 8204751**

(43) Date of publication of application:
**20.06.84 Bulletin 84/25**

(45) Publication of the grant of the patent:
**25.11.87 Bulletin 87/48**

(84) Designated Contracting States:
**AT BE CH DE FR GB IT LI LU NL SE**

(56) References cited:
**EP-A-0 040 893**
**EP-A-0 043 623**
**DE-A-1 447 874**
**DE-B-1 255 491**
**FR-A-1 216 379**
**NL-A-6 602 955**

(73) Proprietor: **STORK SCREENS B.V.**
**Raamstraat 3**
**NL-5831 AT Boxmeer (NL)**

(72) Inventor: **van der Velden, Hendricus Johannes**
**Dukatendreef 9**
**NL-5431 RN Cuyk (NL)**

(74) Representative: **Mathol, Heimen et al**
**EXTERPATENT Willem Witsenplein 4**
**NL-2596 BK 's-Gravenhage (NL)**

Courier Press, Leamington Spa, England.

## Description

The invention relates to a method of forming a printing sleeve, in which at least one sheet of a thermoplastic elastomeric composition which is hardenable under the influence of light (a photopolymer) is applied upon a surface formed by a cylinder, gas permeable means being provided at the cylinder surface which extend at least along the entire inside and full width of the sheet applied upon said cylinder surface, in such a manner that the sheet is pressed against the cylinder surface with the aid of a decreased gas pressure so that, by applying said pressure in conjunction with heat, the sheet is secured to the cylinder.

Such a method is known from EP—A—0 040 893, which describes the use of a cylindrical core whose outer surface is provided with channels extending from one to the other end face of the cylinder and as result of which a gas inclusion is prevented form occurring.

This known method has a drawback that the cylindrical core not economically may be reused once a photopolymer layer has been applied to its surface.

Upon removal of the photopolymer layer residues of hardened photopolymer will remain in the recessions or channels of the cylindrical core thus preventing a uniform bonding of the photopolymer layer in a subsequent use.

Only with very much effort and with use of specialized, expensive solvents the residue may removed, thus making the method very unattractive.

The object of the present invention is to provide a method which does not suffer the aforementioned drawback and which, by using simple means, affords maintaining a small clearance between the photopolymer sheet and the cylinder surface, thus ensuring an uninhibited discharge of gas during the making of the printing sleeve.

According to the invention, said object is attained in the method which is characterized in that:

— a cylinder with a smooth surface is provided,

— a gas-permeable means consisting of a knitted fabric of a plastic-fibre multifilament having a total thread thickness between 10 and 200 µm with a mesh value between 8 and 100 openings/10 cm, is placed around the cylinder surface,

— and heating is applied and carried out to come close to the plasticizing point of the photopolymer, thus causing the knitted fabric to become enveloped in the sheet of the photopolymer, the photopolymer material thereby becoming bonded to said knitted fabric and to the outer surface of the cylinder used.

These measures ensure that, as a result of the heating and the reduced gas pressure, during the last phase of the method, the knitted fabric is completely enveloped by the photopolymer. A perfectly smooth outer surface of the printing sleeve is obtained as a result of a fusing of the sheet. In a favourable embodiment of the invention, the knitted fabric consists of a polyamide multifilament.

With regard to the invention FR—A—1,216,379 and DE—B—1,255,491 are mentioned.

FR—A—1,216,379 describes a cylindrical roller which is covered by a photosensitive layer which includes a wire net.

The wire net in that case is not covered in those areas of the final pattern in which in a final step the photosensitive material is removed. These are the same areas which during printing are filled with ink, which ink is transferred to a substrate during printing. The wire net during printing contacts the substrate and influences therefore the printing result. The wire net present in the photopolymer layer of the cylinder produced according to the method of the invention will not contact the substrate and has no appreciable influence on the printing result.

DE—B—1,255,491 describes a printing form which has a close resemblance to the form described in FR—A—1,216,379. Also in this case a reinforcing wire net is present in a photosensitive layer; after development the wire net is still present in the free areas corresponding to the not-hardened portions of the photosensitive layer. Upon printing the wire net will contact the substrate unlike in the printing cylinder obtained with use of the method according to the invention.

It is to be noted that said method can be used for any smooth surface, i.e. for metal cylinder surfaces but also for, for example, rubber surfaces. In the event, when working according to the serrated method, only serration-conformable materials can be used, the present method also affords utilizing as a foundation surfaces which cannot or are hardly capable of being serrated.

A striking advantage of the invention, improving the universal applicability of the proposed method consists in the use of a woven fabric as the required gas-permeable means. A woven fabric in the form of a seamless sleeve or hose can adapt any shape or dimension of the cylindrical core, thus avoiding the need for a stock of gas-permeable means with different dimensions, adapted to the diameter of a whole range of cylindrical cores.

It should furthermore be noted that the reduced gas pressure is applied in a manner as described in the aforementioned EP—A—0 040 893, that is, via the extremities of the cylinder. The possibility that now a smooth cylinder surface can be used means a saving as compared to the method according to the aforementioned prior EP—A—0 040 893. In addition, a certain reinforcement of the printing sleeve is obtained, due to the fact that during heat treatment the knitted fabric is enclosed, either entirely or for the greater part, by the plasticizing photopolymer.

In a preferred embodiment of the invention, the gas-permeable means have a melting temperature between 100° and 200°C, preferably a melting temperature which is just below the plasticizing point of the photopolymer. During heat treatment, due to the melting process, the gas-per-

meable means are completely absorbed by the softened photopolymer material. Said fusing process moreover results in greater smoothness of the outer surface of the printing sleeve, which enhances the quality of the printed material. Said fusing or melting also enables thicker threads to be used in the knitted fabric (with a better gas removal) without any noticeable thickening occurring on the outside face of the sleeve.

Printers often wish to have an elastic surface affording a depth of approximately 10 millimeters. However, the thickness of the sheet itself usually is no more than 3 millimeters. To meet this requirement, according to the invention, the cylinder surface consists of rubber or plastic.

In the embodiment of the method described hereinbefore, according to the invention, the knitted fabric used may be in the form of a seamless sleeve which can be fitted about the cylinder surface in a close relation, thereby acquiring a mesh value in the order of 4 openings/cm (10 meshes/inch).

Implementing the method proceeds from a hollow metal cylinder having a smooth outer surface upon which is applied the knitted fabric made from a plastic multifilament. Siad knitted fabric may be in the form of a jacket which is pulled over the cylinder surface, but these gas-permeable means may also consist of a cut-off piece of said fabric whose ends are in abutment with each other on the cylinder surface. Upon the cylinder so covered, one applies a plate or sheet of a thermoplastic elastomeric composition hardenable under the influence of light. The fabric is positioned upon the smooth cylinder surface in a specific manner, and each sheet is also applied upon the said fabric in that same manner, such that at least one of the edges of the fabric and of each sheet adjoins an extremity of said cylinder. Along this extremity, the gas removal is carried out by suction in a manner as described by the EP—A—0 040 893 previously mentioned. Effectively, prior to heating, a flexible closed layer, such as for instance a 15 μm polyvinyl chloride foil, is wrapped around the outer face of the photosensitive plate or sheet.

Subsequently heating proceeds at a temperature which is in the neighbourhood of the plasticizing point of the photopolymer (the sheet). Said temperature substantially corresponds to the melting temperature of the plastic multifilament and is within the range of 100 to 200°C. The total thread thickness of the multifilament is within the range of 10 to 200 μm, good results being obtained with a total thread thickness of 20—50 μm, preferably 28 μm. The mesh value of the knitted fabric is then between 8 and 100 openings/10 cm. When stretching this knitted fabric over the cylinder surface, a mesh value is obtained in the elongated condition which is of the order of 4 openings/cm.

The ratio of the total thickness of the knitted fabric applied upon the cylinder surface, to the thickness of the plate or sheet is 0.20—0.01.

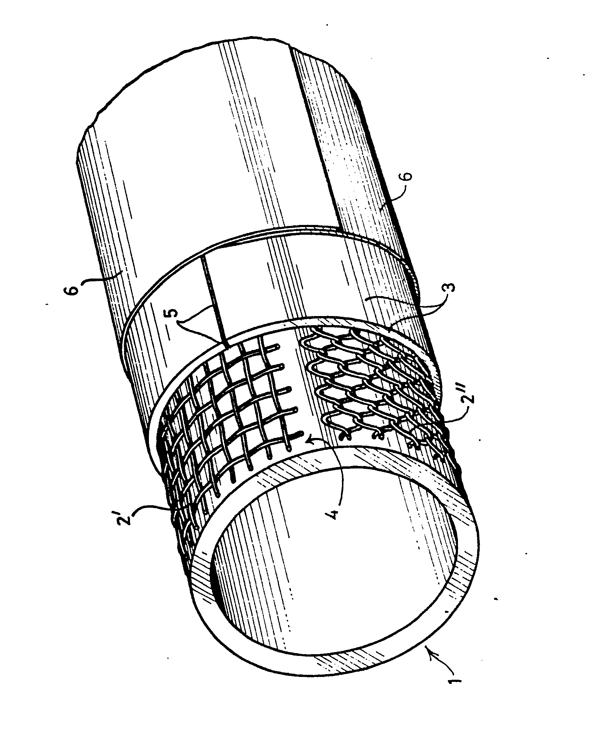

In the following examples, some values are given with reference to the drawing both in relation to the dimensions of the materials used and in relation to the duration of heating and the value of the pressure applied to urge the sheet against the cylinder surface as a result of the underpressure used:

### Example I

Upon a metal cylinder 1 having a surface 4 one applies a polyamide multifilament jacket 2 having a value of 4 openings/cm when in elongated position on the cylinder.

The cylinder so enclosed by the jacket is covered with a plate or sheet 3 of a thermoplastic elastomeric composition which is hardenable under the influence of light (Cyrel of Dupont). The edges 5 of the sheet 3 are brought into close-fitting abutment with each other.

Thereupon, the assembly is placed into an apparatus as described in EP—A—0 040 893. By creating a pressure less than atmospheric, in which case the absolute pressure is no more than 50 cm of mercury column, preferably 28 cm of mercury column (3 kPa), the gases present between the sheet 3 and the surface 4 are removed by suction. Subsequently, a polyvinylchloride foil 6 having a thickness of 15 μm is wrapped around the assembly. Thereupon, heating takes place up to a temperature of 140°C, said heating being maintained for one hour.

After expiration of this time lapse, suction is terminated, the wrapping foil 6 is removed, and heating proceeds at 140°C for another half hour. When fitting the wrapping foil 6 of polyvinylchloride into place, it is necessary to ensure that the overlapping parts are at a proper distance from the seam formed by the abutment edges 5 of the sheet 3. Thereupon, the assembly is cooled and a printing cylinder is obtained which is consolidated with the sheet 3 in an optimum fashion, whereupon said sheet 3 can be provided with the desired pattern.

It is to be noted that in the drawing the jacket 2 is illustrated as a woven web 2' and a knitted fabric 2" in order to show the advantage of the versatility of the latter.

### Example II

This example is similar to Example I; however, the surface whereupon the closed photopolymer layer is to be applied now consists of the surface of a thin-walled, conceivably slightly conical cylinder having a smooth surface, in professional circles knows as a dud.

In order to facilitate a proper fitting of the sealings of the cylindrical closing covers, auxiliary rings are internally provided at the extremities of the cylinder, said rings being affixed to the inner surface of the cylinder, for example, by means of a temporary glue.

Effectively, while fitting the woven web or knitted-fabric jacket as in Example I and applying the photopolymer sheet, the cylinder is supported on the inside by an inflated rubber bag. After fitting the foil wrapping, this bag is removed. The auxiliary rings are removed after performing the heat treatments.

## Claims

1. A method of forming a printing element, in which at least one sheet (3) of a thermoplastic elastomeric composition which is hardenable under the influence of light (a photopolymer) is applied upon a surface (4) formed by a cylinder (1), gas-permeable means (2) being provided at the cylinder surface (4) which extend at least along the entire inside and full width of the sheet applied upon said cylinder surface, in such a manner that sheet is pressed against the cylinder surface with the aid of a decreased gas pressure so that, by applying said pressure in conjunction with heat, the sheet is secured to the cylinder, characterized in that
— a cylinder with a smooth surface is provided,
— a gas permeable means consisting of a knitted fabric (2″) of a plastic-fibre multifilament having a total thread thickness between 10 and 200 µm with a mesh value between 8 and 100 openings/10 cm, is placed around the cylinder surface,
— and heating is applied and carried out to come close to the plasticizing point of the photopolymer, thus causing the knitted fabric (2″) to become enveloped in the sheet (3) of the photopolymer, the photopolymer material thereby becoming bonded to said knitted fabric and to the outer surface of the cylinder used.

2. A method according to claim 1, characterized in that a gas-permeable means consisting of a polyamide multifilament is used.

3. A method according to claim 1, characterized in that a gas-permeable means having a melting temperature between 100° and 200°C, preferably just below the plasticizing point of the photopolymer is used.

4. A method according to claim 1, 2 or 3, characterized in that a cylinder surface (4) consisting of rubber or plastic is provided.

5. A method according to claim 1, characterized in that the knitted fabric is used in the form of a seamless sleeve or jacket (2), which can be fitted around the cylinder surface in a close relation and thereby acquires a mesh value in the order of 4 openings/cm.

6. A method according to claim 1 or 2, characterized in that the multifilament of the fabric used has a total thread thickness of 20—50 µm, preferably 28 µm.

7. A method to any one of the preceding claims, characterized in that the ratio of the total thickness of the fabric applied upon the cylinder surface, to the thickness of the sheet is 1:5—100.

8. A method according to any one of the preceding claims, characterized in that the heating applied takes place during 60 minutes, while maintaining a difference in pressure of 3 kPa, said process being continued for another half hour without suction, whether or not following a preceding cooling.

## Patentansprüche

1. Verfahren zum Herstellen eines Druckelements, bei welchem wenigstens eine Folie (3) aus einer thermoplastischen, elastomeren Zusammensetzung, die unter dem Einfluß von Licht härtbar ist (ein Photopolymer), auf einer von einem Zylinder (1) gebildeten Oberfläche (4) aufgebracht wird, wobei eine gaspermeable Einrichtung (2) an der Zylinderoberfläche (4) angeordnet ist, die sich wenigstens längs der gesamten Innenseite und über die volle Breite der auf die Zylinderoberfläche aufzubringenden Folie erstreckt derart, daß die Folie gegen die Zylinderoberfläche unter Zuhilfenahme eines verminderten Gasdrucks gedrückt wird, so daß durch Anwendung des Drucks in Zusammenwirken mit Wärme die Folie an dem zylinder befestigt wird, dadurch gekennzeichnet, daß
— ein Zylinder mit einer glatten Oberfläche vorgesehen ist,
— eine gaspermeable Einrichtung aus einem Strickstoff (2″) aus einem Plastikfasermultifilament einer Gesamtfadendicke zwischen 10 und 200 µm mit einem Maschenwert zwischen 8 und 100 Öffnungen/10 cm um die Zylinderoberfläche angeordnet wird,
— und eine Erwärmung zugeführt und ausgeführt wird, um dicht an den Plastifizierungspunkt des Photopolymers zu kommen, so daß bewirkt wird, daß der Strickstoff (2″) in der Folie (3) aus Photopolymer eingehüllt wird, wodurch das Photopolymermaterial mit dem Strickstoff und mit der Außenfläche des verwendeten Zylinders fest verbunden wird.

2. Verfahren nach Anspruch 1, dadurch gekennzeichnet, daß eine aus einem Polyamidmultifilament bestehende gaspermeable Einrichtung verwendet wird.

3. Verfahren nach Anspruch 1, dadurch gekennzeichnet, daß eine gaspermeable Einrichtung einer Schmelztemperatur zwischen 100° und 200°C, bevorzugt gerade unter dem Plastifizierungspunkt des Photopolymers, verwendet wird.

4. Verfahren nach Anspruch 1, 2 oder 3, dadurch gekennzeichnet, daß eine Zylinderoberfläche (4), die aus Gummi oder Plastik besteht, vorgesehen ist.

5. Verfahren nach Anspruch 1, dadurch gekennzeichnet, daß der Strickstoff in Form einer nahtlosen Hülle oder eines nahtlosen Mantels (2) verwendet wird, die bzw. der um die Zylinderoberfläche dicht anliegend angebracht werden kann und dabei einen Maschenwert in der Größenordnung von 4 Öffnungen/cm bietet.

6. Verfahren nach Anspruch 1 oder 2, dadurch gekennzeichnet, daß das Multifilament des verwendeten Stoffs eine Gesamtfadendicke von 20 bis 50 µm, vorzugsweise 28 µm aufweist.

7. Verfahren nach einem der vorhergehenden Ansprüche, dadurch gekennzeichnet, daß das Verhältnis der Gesamtdicke des auf der Zylinderoberfläche angebrachten Stoffs zur Dicke der Folie zwischen 1:5 und 1:100 liegt.

8. Verfahren nach einem der vorhergehenden Ansprüche, dadurch gekennzeichnet, daß die Erwärmung während 60 Minuten stattfindet, während eine Druckdifferenz von 3 kPa aufrechterhalten wird, wobei das Verfahren für eine weitere 1/2 Stunde ohne Saugwirkung fortgesetzt wird, gegebenenfalls im Anschluß an einen vorhergehenden Kühlvorgang.

## Revendications

1. Méthode pour réaliser un élément pour l'impression dans laquelle au moins une feuille (3) de matériau élastomère thermoplastique est durcissable sous l'effet de la lumière (un photopolymère) est appliquée sur une surface (4) d'un cylindre (1), des moyens perméables au gaz (2) étant disposés à la surface cylindrique (4) et qui s'étendent au moins sur toute la face intérieure et la largeur entière de la feuille appliquée à ladite surface cylindrique de manière telle, que la feuille soit pressée contre la surface cylindrique lors de la création d'une dépression pour fixer la feuille au cylindre lors de l'application de ladite dépression et de la chaleur, caractérisée en ce que
— on dispose d'un cylindre à face lisse,
— les moyens perméables au gaz consistant en un tricot (2″) fait en un multifilament de fibres plastiques, l'épaisseur totale du fil variant entre 10 et 200 µm et dont la valeur de maille se situe entre 8 et 100 ouvertures par 10 cm, s'étendent autour de la surface cylindrique,
— on applique la chaleur, de façon à approcher le point de plasticité du photopolymère, réalisant ainsi l'enveloppement du tricot (2″) par la feuille

(3) du photopolymère et la liaison de la matière photopolymérique avec le tricot et avec la surface externe du cylindre utilisé.

2. Méthode selon la revendication 1, caractérisée en ce qu'on utilise un multifilament de polyamide comme moyens perméables au gaz.

3. Méthode selon la revendication 1, caractérisée en ce que la température de fusion des moyens perméables au gaz varie entre 100 et 200°C et se situe de préférence juste au dessous du point de plastification du photopolymère utilisé.

4. Méthode selon l'une des revendications 1, 2 ou 3, caractérisée en ce qu'on dispose d'un cylindre dont la surface (4) est en caoutchouc ou en matière plastique.

5. Méthode selon la revendication 1, caractérisée en ce que le tricot a la forme d'un manchon ou d'une enveloppe (2) sans couture, qui s'applique de près autour de la surface cylindrique et de cette façon possède une valeur de maille de l'ordre de 4 ouvertures par cm.

6. Méthode selon la revendication 1 ou 2, caractérisée en ce que l'épaisseur totale du fil du multifilament du tricot est de 20 à 50 µm, de préférence de 28 µm.

7. Méthode selon l'une des revendications 1 à 6, caractérisée en ce que le rapport de l'épaisseur totale du tricot appliqué à la surface cylindrique à l'épaisseur de la feuille est de 1 : 5—100.

8. Méthode selon l'une des revendications 1 à 7, caractérisée en ce qu'on procède au chauffage pendant 60 minutes tout en maintenant une dépression de 3 kPa, puis au chauffage sans suction précédé ou non du refroidissement.